# EUROPÄISCHE PATENTSCHRIFT

(11) **EP 1 004 145 B1**
(45) Veröffentlichungstag und Bekanntmachung des Hinweises auf die Patenterteilung: **01.06.2005**
(21) Anmeldenummer: 98947353.3
(22) Anmeldetag: 27.07.1998
(51) Int. Cl.: H01L 33/00

(54) **OPTOELEKTRONISCHES BAUELEMENT**
OPTOELECTRONIC COMPONENT
COMPOSANT OPTOELECTRONIQUE

(30) Priorität: 29.07.1997 DE 19732646
(43) Veröffentlichungstag der Anmeldung: 31.05.2000
(73) Patentinhaber: Osram Opto Semiconductors GmbH, 93049 Regensburg (DE)
(72) Erfinder: ARNDT, Karlheinz, D-93049 Regensburg (DE)
(74) Vertreter: Epping, Hermann, Fischer
(86) Internationale Anmeldenummer: PCT/DE1998/002125
(87) Internationale Veröffentlichungsnummer: WO 1999/007023

(56) Entgegenhaltungen:
- WO-A-98/20718
- DE-A- 19 536 454
- US-A- 5 146 310
- US-A- 5 289 344
- PATENT ABSTRACTS OF JAPAN vol. 018, no. 556 (E-1620), 24. Oktober 1994 -& JP 06 204604 A (SANYO ELECTRIC CO LTD), 22. Juli 1994
- PATENT ABSTRACTS OF JAPAN vol. 009, no. 225 (E-342), 11. September 1985 -& JP 60 081877 A (SHARP KK), 9. Mai 1985

## Beschreibung

Die Erfindung bezieht sich auf ein optoelektronisches oberflächenmontierbares Bauelement (SMD), bei dem ein optoelektronischer Chip mittels eines gut wärmeleitenden Verbindungsmittels auf einem eine erste Hauptfläche bildenden Chipträgerteil eines Leiterrahmens (Leadframe) befestigt ist, bei dem der Leiterrahmen ein in einem Abstand zum Chipträgerteil angeordnetes Anschlussteil aufweist, das mit einem elektrischen Kontakt des optoelektronischen Chips elektrisch leitend verbunden ist, und bei dem der optoelektronische Chip und ein Teil des Leiterrahmens von einer einen Grundkörper bildenden Umhüllung umgeben sind, wobei der Grundkörper eine der ersten Hauptfläche gegenüberliegende nach außen gewandte zweite Hauptfläche bildet, und im Leiterrahmen vorgesehene externe Anschlüsse des Chipträgerteiles und des Anschlussteiles aus der Umhüllung herausragen, wobei die externen Anschlüsse außerhalb des Grundkörpers zunächst zu der der ersten Hauptfläche gegenüberliegenden zweiten Hauptfläche des Grundkörpers hin und im weiteren Verlauf entweder unterhalb des Grundkörpers zu dessen Mitte hin gebogen sind oder zu schwingenförmigen Anschluss-Stummeln vom Grundkörper weg gebogen sind. Sie bezieht sich im Speziellen auf ein optoelektronisches Bauelement mit einem optoelektronischen Halbleiterchip, insbesondere mit einem bei hoher Leistung betriebenen Leuchtdioden-Chip (LED).

Ein solches Bauelement ist beispielsweise aus der europäischen Patentanmeldung EP 400 176 bekannt. Hierin ist eine sogenannte TOPLED beschrieben, bei der ein lichtemittierender Halbleiterchip (LED-Chip) auf einem ebenen Chipträgerteil eines Leiterrahmens befestigt ist. Der Leiterrahmen setzt sich zusammen aus dem Chipträgerteil und einem in einem Abstand zu diesem, also elektrisch isoliert von diesem angeordneten Anschlussteil mit jeweils einem externen Anschluss. Der Chipträgerteil mit dem Halbleiterchip, der Anschlussteil und Teilbereiche der externen Anschlüsse sind von einer Umhüllung umgeben, die aus einem strahlungsundurchlässigen Grundkörper mit einer Ausnehmung und einem diese Ausnehmung ausfüllenden strahlungsdurchlässigen Fensterteil besteht. Der Chipträgerteil und der Anschlussteil sind derart von dem Grundkörper umgeben bzw. in diesen eingebettet, dass Teilbereiche der Oberseiten des Chipträgerteils und des Anschlussteils mit der verbleibenden Bodenfläche der Ausnehmung bündig abschließen. Der Halbleiterchip ist bis auf seine Unterseite, mit der er auf dem Chipträgerteil aufliegt, vollständig von dem strahlungsdurchlässigen Fensterteil umgeben. Die Ausnehmung und deren Innenflächen sind derart geformt und angeordnet, dass sie für die vom Halbleiterchip ausgesandte Strahlung einen im Wesentlichen kegelstumpfförmigen Reflektor bildet.

In der DE 19536454A1 ist ein optoelektronisches Bauelement beschrieben, bei dem zur Verbesserung der Wärmeableitung vom Halbleiterchip zwei externe Anschlüsse des Chipträgerteiles des Leiterrahmens gegenüber den externen Anschlüssen des Anschlußteiles verbreitert sind.

Bei den oben beschriebenen bekannten optoelektronischen Bauelementen kommt es bei Betrieb des Halbleiterchips bei hohen Strömen und damit bei hoher Leistung, wie es beispielsweise bei sogenannten Power-LEDs der Fall ist, aufgrund von unzureichender Wärmeableitung vom Halbleiterchip, zu dessen starker Erhitzung. Diese Erhitzung führt häufig zur Beeinträchtigung der Funktionsfähigkeit des Halbleiterchips, wie z. B. beschleunigte Alterung, Abbrechen des Halbleiterchips vom Leiterrahmen, Abbrechen der Bonddrähte oder Zerstörung des Chips. Die bekannten verbreiterten externen Anschlüsse des Chipträgerteiles begünstigen eine Delamination des Kunststoffes vom Leiterrahmen, die z. B. ein Eindringen von Feuchtigkeit zum Halbleiterchip hervorrufen kann.

Der Erfindung liegt daher die Aufgabe zugrunde, das optoelektronische Bauelement der eingangs genannten Art so weiterzubilden, dass eine verbesserte Wärmeableitung vom Chip gewährleistet ist, ohne gleichzeitig die Gehäuseabmessungen wesentlich zu verändern und ohne gleichzeitig die Delaminationsgefahr wesentlich zu erhöhen.

Diese Aufgabe wird durch ein Bauelement mit den Merkmalen des Anspruches 1 gelöst.

Vorteilhafte Weiterbildungen der erfindungsgemäßen Bauelemente sind Gegenstand der Unteransprüche.

Bei dem erfindungsgemäßen Bauelement ist vorgesehen, dass der Chipträgerteil mindestens drei separate, mit dem Chipträgerteil thermisch leitend verbundene externe Anschlüsse aufweist, die an verschiedenen, einen Abstand voneinander aufweisenden Stellen der Umhüllung aus dieser herausragen und die derart geformt sind, daß sie im auf einer für die Montage des Bauelements vorgesehenen Leiterplatte montierten Zustand des Bauelements alle gleichzeitig auf der Anschluß- oder Leiterplatte aufliegen. Die im Betrieb des Bauelements im Chip entstehende Wärme wird folglich an drei verschiedenen Punkten in die Leiterplatte eingespeist und großflächig auf dieser verteilt. Dadurch wird eine deutlich verbesserte Wärmeableitung vom optoelektronischen Chip erzielt.

Bei dem erfindungsgemäßen Bauelement verlaufen die externen Anschlüsse des Chipträgerteiles in Draufsicht auf den Leiterrahmen gesehen, ausgehend von dem Chipträgerteil getrennt voneinander im Wesentlichen sternförmig nach außen. Die Wärmeableitungspunkte vom Bauelement zur Leiterplatte hin weisen dadurch verhältnismäßig große Abstände voneinander auf, wodurch eine sehr großflächige Verteilung der im Betrieb des Bauelements über den Chipträgerteil und dessen externe Anschlüsse vom Chip abgeleiteten thermischen Energie auf die Leiterplatte erreicht wird.

Vorteilhafterweise weisen die externen Anschlüsse in dem Bereich, in dem sie sternförmig nach außen verlaufen, Längsmittelachsen auf, von denen zwei zueinander benachbarte jeweils einen Winkel von etwa 90° einschließen. Bei dieser Anordnung ist der Kunststoffbereich zwischen den Anschlüssen maximal, wodurch die Delaminationsgefahr z. B. bei Temperaturschwankungen verringert ist.

Selbstverständlich können optional die externen Anschlüsse des Chipträgerteiles breiter sein als die externen Anschlüsse des Anschlussteiles.

Weitere Vorteile und bevorzugte Ausführungsformen ergeben sich aus den im folgenden in Verbindung mit den Figuren 1 bis 3b näher erläuterten Ausführungsbeispielen. Es zeigen:
Figur 1a eine schematische Darstellung einer Draufsicht eines Ausführungsbeispieles eines erfindungsgemäßen Bauelements mit einem einzigen optoelektronischen Chip,
Figur 1b eine schematische Darstellung eines Schnittes durch das Ausführungsbeispiel von Figur 1 entlang der Linie A-A,
Figur 2 eine schematische Darstellung einer Draufsicht eines Ausführungsbeispieles eines Bauelements mit mindestens zwei optoelektronischen Chips, das nicht der Erfindung entspricht,
Figur 3a eine schematische Darstellung einer Seitenansicht eines Ausführungsbeispieles eines seitlich emittierenden Bauelements, das ebenfalls nicht der Erfindung entspricht, und
Figur 3b eine schematische Darstellung eines Schnittes durch das Ausführungsbeispiel von Figur 3 entlang der in Figur 3 eingezeichneten Linie A-A.

In den Figuren sind gleiche und gleichwirkende Bestandteile der verschiedenen Ausführungsbeispiele immer mit denselben Bezugszeichen versehen.

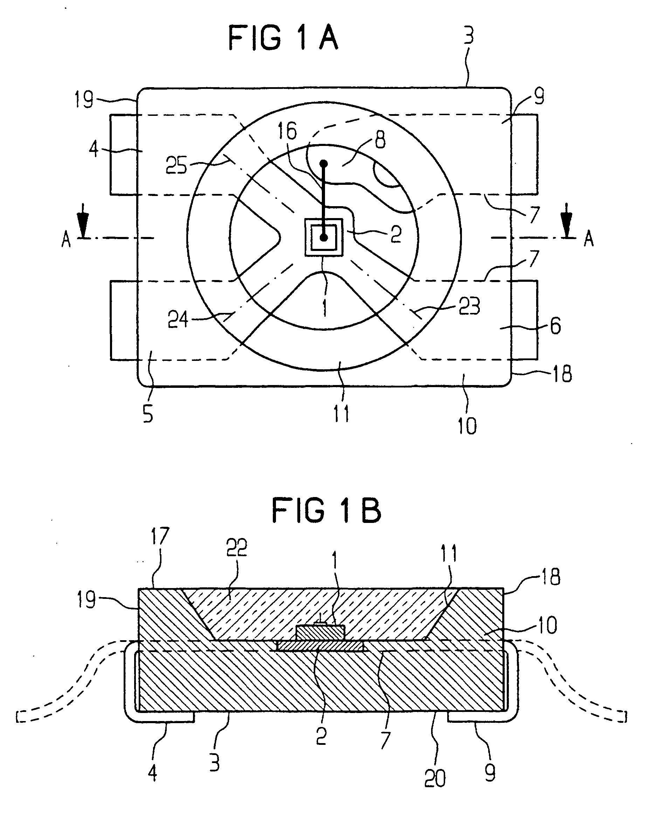

Bei dem Bauelement gemäß Figur 1 handelt es sich um ein Leuchtdioden-Bauelement, bei dem auf einem Chipträgerteil 2 eines Leiterrahmens (Leadframe) 7 ein lichtemittierender Halbleiterchip 1 (LED-Chip) mittels eines gut wärmeleitenden Verbindungsmittels, z. B. mittels eines metallischen Lotes befestigt ist. Drei separate externe Anschlüsse 4, 5, 6 erstrecken sich ausgehend vom Chipträgerteil 2 in drei verschiedene Richtungen nach außen. In einem Abstand zum Chipträgerteil 2 mit den externen Anschlüssen 4, 5, 6 ist ein Anschlussteil 8 mit einem externen Anschluss 9 angeordnet, der mittels eines Bonddrahtes 16 mit einem elektrischen Kontakt des LED-Chips 1, z. B. mit der Anodenkontaktierung verbunden ist. Eine zweite Kontaktmetallisierung (Kathodenkontaktierung) des LED-Chips 1 befindet sich beispielsweise an dessen dem Chipträgerteil 2 zugewandten Unterseite und ist mit dem Chipträgerteil 2 mittels dem in diesem Fall auch elektrisch leitenden Verbindungsmittel elektrisch leitend verbunden. Der Chipträgerteil 2 mit den externen Anschlüssen 4, 5, 6 dient folglich in diesem Fall sowohl als Kathodenanschluss als auch als thermischer Anschluß zur Wärmeableitung vom LED-Chip.

Ist die Kathodenkontaktierung nicht, wie im oben genannten Fall, an der Unterseite des Chips 1 angeordnet, sondern z. B. an dessen Oberseite, kann diese mittels eines Bonddrahtes mit dem Chipträgerteil 2 elektrisch leitend verbunden sein.

Der Chipträgerteil 2, der Anschlussteil 8 und Teilbereiche von deren externen Anschlüsse 4, 5, 6, 9 sind von einem im Wesentlichen quaderförmigen Grundkörper 10 einer Umhüllung 3 umschlossen, der eine Ausnehmung 11 aufweist. Die Ausnehmung 11 hat im Wesentlichen die Form eines Kegelstumpfes und reicht von einer zum Leiterrahmen 7 parallel liegenden Hauptfläche 17 des Grundkörpers 10 bis zum Leiterrahmen 7, wobei sich der Querschnitt der Ausnehmung 11 vom Leiterrahmen 7 zur Hauptfläche 17 des Grundkörpers 10 hin vergrößert. Der LED-Chip 1 befindet sich in der Ausnehmung 11, die mit einem strahlungsdurchlässigen Fensterteil 22, bevorzugt mit einem transparenten Kunststoffverguss versehen ist. Dieser Fensterteil 22 bildet zusammen mit dem Grundkörper 10 eine Umhüllung 3 des Bauelements. Die externen Anschlüsse 4, 5, 6, 9 ragen auf einander gegenüberliegenden Seitenflächen 18,19 des Grundkörpers 10 aus diesem heraus. Sie verlaufen innerhalb des Grundkörpers 10 ausgehend von dem Chipträgerteil 2 zunächst im Wesentlichen sternförmig auseinander und knicken im weiteren Verlauf ab, derart, dass sie die Seitenflächen 18,19 senkrecht durchdringen.

Der Chipträgerteil 2 liegt bevorzugt vollständig innerhalb der Bodenfläche der Ausnehmung 11.

Die externen Anschlüsse 4,5,6,9 weisen in dem Bereich, in dem sie sternförmig nach außen verlaufen, Längsmittelachsen 23,24,25 auf, von denen jeweils zwei zueinander benachbarte einen Winkel von etwa 90° einschließen.

Die externen Anschlüsse 4, 5, 6, 9 sind außerhalb des Grundkörpers 10 zunächst zu der der ersten Hauptfläche 17 gegenüberliegenden zweiten Hauptfläche 20 des Grundkörpers 10 hin und im weiteren Verlauf unterhalb des Grundkörpers 10 zu dessen Mitte hin gebogen. Sie können aber auch, wie in Figur 1b gestrichelt angedeutet, zu schwingenförmigen Anschluss-Stummeln gebogen sein. Auch dies stellt eine an sich in der Oberflächenmontage-Technik übliche Form der externen elektrischen Anschlüsse dar. Diese Arten von externen Anschlüssen für oberflächenmontierbare-Bauelemente (SMD) sind an sich bekannt und werden von daher an dieser Stelle nicht näher erläutert.

Die externen Anschlüsse sind folglich derart geformt, daß sie im auf einer für die Montage des Bauelements vorgesehenen Leiterplatte montierten Zustand des Bauelements alle gleichzeitig auf der Anschluß- oder Leiterplatte aufliegen.

Die Innenflächen der Ausnehmung 11 bilden einen Reflektor für die vom LED-Chip 1 im Betrieb des Bauelements ausgesandte Strahlung. Sie sind optional mit einem reflexionssteigernden . Material beschichtet. Alternativ kann der Grundkörper aus einem reflexionssteigernden Material bestehen.

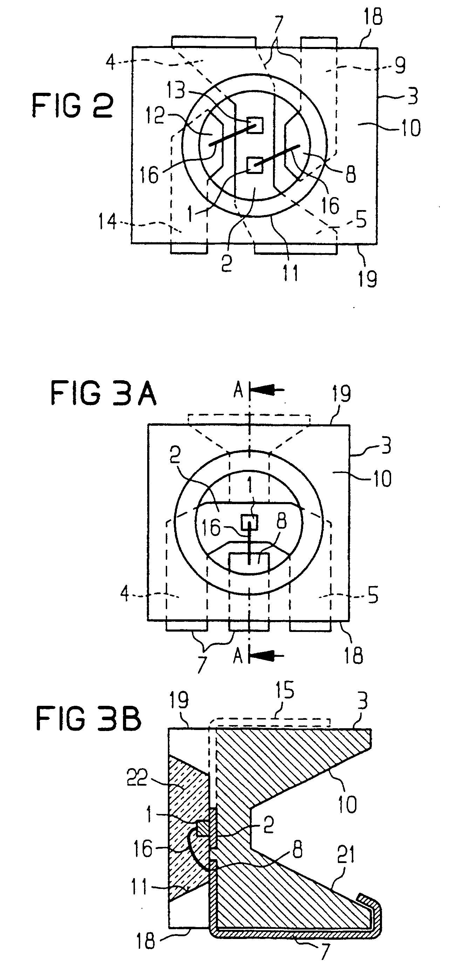

Bei dem Bauelement von Figur 2 sind im Unterschied zum Ausführungsbeispiel der Figuren 1a und 1b auf einem Chipträgerteil 2 eines Leiterrahmens 7 zwei verschiedenfarbig leuchtende LED-Chips 1, 13 mittels eines thermisch und elektrisch leitenden Verbindungsmittels befestigt. Auf gegenüberliegenden Seiten des Chipträgerteiles 2 sind in einem Abstand zu diesem ein erster 8 und ein zweiter Anschlussteil 12 angeordnet, von denen jeder einen externen Anschluss 9,14 aufweist. Diese externen Anschlüsse 9,14 verlaufen parallel versetzt zueinander, erstrecken sich, gesehen vom Chipträgerteil 2, in zueinander entgegengesetzten Richtungen und ragen auf einander gegenüberliegenden Seitenflächen 18,19 des Grundkörpers 10 aus diesem heraus. Sie sind mittels Bonddrähten 16 mit den Anodenkontaktierungen der LED-Chips 1,13 elektrisch leitend verbunden.

Das Chipträgerteil 2 weist zwei externe Anschlüsse 4,5 auf, die sich ausgehend vom Chipträgerteil 2 im Wesentlichen ebenfalls parallel versetzt zueinander in zueinander entgegengesetzten Richtungen parallel zu den externen Anschlüssen 9,14 der Anschlussteile 8,12 erstrecken und auf einander gegenüberliegenden Seitenflächen 18,19 des Grundkörpers 10 aus diesem herausragen.

Wie beim Ausführungsbeispiel der Figuren 1a und 1b, weist der strahlungsundurchlässige Grundkörper 10 eine kegelstumpfförmigen Ausnehmung 11 auf, die mit einem transparenten Fensterteil 22 versehen ist. Die LED-Chips 1,13 befinden sich in dieser der Ausnehmung 11.

Die externen Anschlüsse 4,5,9,14 ragen auf einander gegenüberliegenden Seitenflächen 18,19 des Grundkörpers 10 aus diesem heraus. Sie sind außerhalb des Grundkörpers 10 analog zum Ausführungsbeispiel gemäß Figuren 1a und 1b geformt.

Bei den oben beschriebenen Bauelementen sind jeweils die Umhüllung 3 und die externen Anschlüsse 4,5,6,9,14 derart ausgebildet, dass im Betrieb des Bauelements die vom bzw. von den LED-Chip/s ausgesandte Strahlung im Wesentlichen senkrecht zur Montageoberfläche einer für die Montage des Bauelements vorgesehenen Leiterplatte abgestrahlt wird.

Bei dem Bauelement der Figur 3a und 3b handelt es sich um ein sogenanntes seitlich emittierendes LED-Bauelement. Die Umhüllung 3 und die externen Anschlüsse 4,5 und 9 des Chipträgerteiles 2 bzw. des Anschlussteiles 8 sind bei diesem Bauelement derart ausgebildet, dass es mit einer Seitenfläche 20 des Grundkörpers 10 zur Montagefläche einer Leiterplatte hin auf dieser befestigt werden kann.

Hierzu weist ein Leiterrahmen 7 einen Chipträgerteil 2 auf, der mindestens zwei externe Anschlüsse 4,5 besitzt. Diese externen Anschlüsse 4,5 erstrecken sich zunächst ausgehend vom Chipträgerteil 2, auf dem ein LED-Chip 1 mittels eines thermisch und elektrisch leitenden Verbindungsmittels befestigt ist, in im Wesentlichen entgegengesetzten Richtungen nach außen. Im weiteren Verlauf knicken sie in dieselbe Richtung ab, so dass sie anschließend parallel zueinander in die gleiche Richtung verlaufen. Zwischen den beiden externen Anschlüssen 4,5 des Chipträgerteiles 2 ist ein Anschlussteil 8 mit einem externen Anschluss 9 angeordnet, der parallel zu den beiden externen Anschlüssen 4,5 des Chipträgerteiles in dieselbe Richtung wie diese verläuft.

Der Chipträgerteil 2, dessen externe Anschlüsse 4,5, der Anschlussteil 8 und dessen externer Anschluss 9 sind analog zu den beiden oben beschriebenen Ausführungsbeispielen mit einem strahlungsundurchlässigen Grundkörper 10 umschlossen, der eine kegelstumpfförmige Ausnehmung 11 aufweist, in dem der LED-Chip 1 angeordnet ist. Die Ausnehmung 11 ist auch hier mit einem strahlungsdurchlässigen Fensterteil 22 versehen, der bevorzugt aus einem strahlungsdurchlässigen Kunststoff besteht. Die externen Anschlüsse 4,5,9 ragen auf ein- und derselben Seitenfläche 18 des Grundkörpers 10 aus diesem heraus, sind außerhalb des Grundkörpers 10 nach unten in Richtung Rückseite des Grundkörpers 10 gebogen und sind im weiteren Verlauf entlang der Rückseite 21 des Grundkörpers 10 zu dessen Mitte hin gebogen. Die von der Seitenfläche 18 des Grundkörper 10 abgewandten Außenflächen der externen Anschlüsse 4,5,9 bilden eine Auflagefläche des Bauelements zu dessen Montage auf einer Leiterplatte.

Zur zusätzlichen Kühlung des LED-Chips 1 kann der Chipträgerteil 2 mit einer Kühlfahne 15 aufweisen (in den Figuren 3a und 3b gestrichelt eingezeichnet). Diese ragt auf einer der Seitenfläche 18, aus dem die externen Anschlüsse 4,5,9 herausragen, gegenüberliegenden Seitenfläche 19 des Grundkörpers 10 aus diesem heraus und ist außerhalb des Grundkörpers 10 zu dessen Rückseite 21 hin gebogen, derart, dass sie auf der Seitenfläche 19 aufliegt. An diese Kühlfahne 15 können optional weitere Kühleinrichtungen thermisch angeschlossen werden.

Bei allen oben beschriebenen Ausführungsbeispielen, bzw. Bauelementen sind bevorzugt die externen Anschlüsse des Chipträgerteiles 2 breiter als die externen Anschlüsse des bzw. der Anschlussteile 8,12. Damit kann bei im Wesentlichen unveränderter Gehäuseabmessung ein weiter verbesserter Wärmeabtransport vom LED-Chip 1 erzielt werden. Die externen Anschlüsse 4, 5, 6, 9, 12 können aber auch alle dieselbe Breite haben.

Um eine weitere Verbesserung des Wärmeabtransports vom LED-Chip zu erreichen, sind auf einer für die Montage des Bauelements vorgesehenen Leiterplatte besonders große Löt-Pads vorgesehen. Diese sind ebenfalls sternförmig angeordnet und können so die vom LED-Chip abgeführte Wärme großflächig auf der Leiterplatte verteilen. Die Leadframes der erfindungsgemäßen Bauelemente führen die Wärme sternförmig vom LED-Chip zur Gehäuseaußenseite. Dadurch wird die Wärme an weit voneinander entfernt liegenden Punkten in die Platine eingespeist. Auf der Platine befinden sich bevorzugt um jeden Löt-Pad große, beispielsweise aus Kupfer bestehende Metallisierungen, die die Wärme auf der Leiterplatte verteilen. Der Wärmewiderstand der erfindungsgemäßen Gehäuse ist gegenüber dem Wärmewiderstand herkömmlicher LED-Gehäuse deutlich reduziert.

Bei den oben beschriebenen Gehäusen für LED-Chips handelt es sich um in der Halbleitertechnik bekannte Gehäuse für optoelektronische Bauelemente. Die besonderen Formen, die dazu verwendeten Materialien und Herstellverfahren werden von daher an dieser Stelle nicht mehr näher erläutert.

Die Beschreibung der Erfindung anhand der Ausführungsbeispiele ist selbstverständlich nicht als Einschränkung der Erfindung auf diese Beispiele zu verstehen.

## Patentansprüche

1. Oberflächenmontierbares optoelektronisches Bauelement (SMD), bei dem ein optoelektronischer Chip (1) mittels eines gut wärmeleitenden Verbindungsmittels auf einem eine erste Hauptfläche (17) bildenden Chipträgerteil (2) eines Leiterrahmens (7) befestigt ist, bei dem der Leiterrahmen (7) ein in einem Abstand zum Chipträgerteil (2) angeordnetes Anschlussteil (8) aufweist, das mit einem elektrischen Kontakt des optoelektronischen Chips (7) elektrisch leitend verbunden ist, und bei dem der optoelektronische Chip (1) und ein Teil des Leiterrahmens (7) von einer einen Grundkörper (10) bildenden Umhüllung (3) umgeben sind, wobei der Grundkörper (10) eine der ersten Hauptfläche (17) gegenüberliegende nach außen gewandte zweite Hauptfläche (20) bildet, und im Leiterrahmen (7) vorgesehene externe Anschlüsse (4, 5, 6, 9) des Chipträgerteiles (2) und des Anschlussteiles (8) aus der Umhüllung (3) herausragen, wobei die externen Anschlüsse (4, 5, 6, 9) außerhalb des Grundkörpers (10) zunächst zu der der ersten Hauptfläche (17) gegenüberliegenden zweiten Hauptfläche (20) des Grundkörpers (10) hin und im weiteren Verlauf entweder unterhalb des Grundkörpers (10) zu dessen Mitte hin gebogen sind oder zu schwingenförmigen Anschluss-Stummeln vom Grundkörper (10) weg gebogen sind,
**dadurch gekennzeichnet,**
**dass** wenigstens drei der externen Anschlüsse als mit dem Chipträgerteil (2) thermisch leitend verbundene Wärmeleit-Anschlüsse (4, 5, 6) ausgebildet sind, die an verschiedenen, einen Abstand voneinander aufweisenden Stellen an wenigstens zwei Seiten der Umhüllung (3) aus dieser herausragen und zur Auflage auf einer Anschluß- oder Leiterplatte vorgesehen sind, wobei die externen Wärmeleit-Anschlüsse (4, 5, 6) in Draufsicht auf den Leiterrahmen (7) gesehen, ausgehend von dem Chipträgerteil (2) innerhalb der Umhüllung (3) getrennt voneinander im Wesentlichen sternförmig nach außen verlaufen.

2. Optoelektronisches Bauelement nach Anspruch 1,
**dadurch gekennzeichnet,**
**dass** die Wärmeleit-Anschlüsse (4,5,6) breiter sind als einer oder mehrere externe Anschlüsse (9, 14) des Anschlussteiles.

3. Optoelektronisches Bauelement nach einem der Ansprüche 1 und 2,
**dadurch gekennzeichnet,**
**dass** der Chipträgerteil (2) mit mindestens einer Kühlfahne (15) wärmeleitend verbunden ist, die auf einer anderen Seitenfläche (19) der Umhüllung (3) als die Wärmeleit-Anschlüsse aus dieser herausragt.

4. Optoelektronisches Bauelement nach einem der Ansprüche 1 bis 3,
**dadurch gekennzeichnet,**
**dass** die Umhüllung (3) vollständig aus einem strahlungsdurchlässigen Material besteht.

5. Optoelektronisches Bauelement nach einem der Ansprüche 1 bis 3,
**dadurch gekennzeichnet,**
**dass** eine Ausnehmung (11) in der den Grundkörper (10) bildenden Umhüllung (3) vorgesehen ist, in der ein strahlungsdurchlässiges Fensterteil (12) angeordnet ist.

6. Optoelektronisches Bauelement nach Anspruch 5,
**dadurch gekennzeichnet,**
**dass** der Chipträgerteil (2) von dem strahlungsundurchlässigen Grundkörper (10) teilweise umhüllt ist, wobei der Chip (1) in der Ausnehmung (11) angeordnet ist.

7. Optoelektronisches Bauelement nach Anspruch 5 oder 6,
**dadurch gekennzeichnet,**
**dass** die Ausnehmung (11) in ihrem Verlauf von innerhalb der Umhüllung (3) nach außen im Querschnitt aufgeweitet ausgebildet ist.

8. Optoelektronisches Bauelement nach Anspruch 7,
**dadurch gekennzeichnet,**
**dass** die Innenfläche(n) der Ausnehmung (11) für die vom Chip (1) ausgesandte und/oder empfangene Strahlung als Reflektor ausgebildet ist/sind.

## Claims

1. Surface-mountable optoelectronic component (SMD), in which an optoelectronic chip (1) is fixed on a chip carrier part (2), forming a first main area (17), of a leadframe (7) by means of a connecting means having good thermal conductivity, in which the leadframe (7) has a connection part (8) which is arranged at a distance from the chip carrier part (2) and is electrically conductively connected to an electrical contact of the optoelectronic chip (7), and in which the optoelectronic chip (1) and a part of the leadframe (7) are surrounded by an encapsulation (3) forming a base body (10), the base body (10) forming an outwardly facing second main area (20) opposite to the first main area (17), and external connections (4, 5, 6, 9) of the chip carrier part (2) and of the connection part (8) which are provided in the leadframe (7) project from the encapsulation (3), the external connections (4, 5, 6, 9), outside the base body (10), firstly being bent towards the second main area (20) of the base body (10) opposite to the first main area (17) and, in the further course, either being bent below the base body (10) towards the centre thereof or being bent away from the base body (10) to form wing-type connection stubs,
**characterized**
**in that** at least three of the external connections are formed as heat-conducting connections (4, 5, 6) which are thermally conductively connected to the chip carrier part (2), and, at different spaced apart locations at at least two sides of the encapsulation (3), project from the latter and are provided for bearing on a connection board or printed circuit board, in which case the external heat-conducting connections (4, 5, 6), as seen in a plan view of the leadframe (7), proceeding from the chip carrier part (2), run outwards within the encapsulation (3) separately from one another essentially in a star-shaped manner.

2. Optoelectronic component according to Claim 1,
**characterized**
**in that** the heat-conducting connections (4, 5, 6) are wider than one or more external connections (9, 14) of the connection part.

3. Optoelectronic component according to either of Claims 1 and 2,
**characterized**
**in that** the chip carrier part (2) is thermally conductively connected to at least one cooling lug (15) which projects from the encapsulation (3) on a different side area (19) of the said encapsulation (3) from the heat-conducting connections.

4. Optoelectronic component according to one of Claims 1 to 3,
**characterized**
**in that** the encapsulation (3) is composed completely of a radiation-transmissive material.

5. Optoelectronic component according to one of Claims 1 to 3,
**characterized**
**in that** provision is made of a recess (11) in the encapsulation (3) forming the base body (10), in which a radiation-transmissive window part (12) is arranged.

6. Optoelectronic component according to Claim 5,
**characterized**
**in that** the chip carrier part (2) is partially encapsulated by the radiation-opaque base body (10), the chip (1) being arranged in the recess (11).

7. Optoelectronic component according to Claim 5 or 6,
**characterized**
**in that** the recess (11) is formed such that its profile is expanded in cross section outwards from within the encapsulation (3).

8. Optoelectronic component according to Claim 7,
**characterized**
**in that** the inner area(s) of the recess (11) is/are formed as a reflector for the radiation emitted and/or received by the chip (1).

## Revendications

1. Composant optoélectronique monté en surface (SMD), tel qu'une puce optoélectronique (1) est fixée par un moyen de liaison bon conducteur de chaleur sur une partie formant support de puce (2), constituant une première surface principale (17), d'un support conducteur (7), que le support conducteur (7) comporte une partie formant connexion (8) qui est disposée à distance de la partie formant support de puce (2) et qui est reliée de façon électriquement conductrice à un contact électrique de la puce optoélectronique (1) et que la puce optoélectronique (1) et une partie du support conducteur (7) sont entourées par une enveloppe (3) formant corps de base (10), le corps de base (10) formant une deuxième surface principale (20) tournée vers l'extérieur et opposée à la première surface principale (17) et des connexions externes (4, 5, 6, 9), prévues dans le support conducteur (7), de la partie formant support de puce (2) et de la partie formant connexion (8) dépassant de l'enveloppe (3), les connexions externes (4, 5, 6, 9) en dehors du corps de base (10) étant pliées d'abord vers la deuxième surface principale (20) du corps de base (10) opposée à la première surface principale (17) et ensuite en dessous du corps de base (10) vers le milieu de celui-ci ou comme des tronçons de connexion en forme de moignons s'éloignant du corps de base (10),
**caractérisé par le fait que**
au moins trois des connexions externes sont conçues comme des connexions conductrices de chaleur (4, 5, 6) qui sont reliées de façon thermiquement conductrice à la partie formant support de puce (2), qui dépassent de l'enveloppe (3) en différents endroits distants les uns des autres sur au moins deux côtés de l'enveloppe et qui sont prévues pour l'appui sur une carte de connexion ou carte imprimée, les connexions externes conductrices de chaleur (4, 5, 6) s'étendant vers l'extérieur globalement en étoile séparément les unes des autres, dans une vue de dessus du support conducteur (7), à partir de la partie formant support de puce (2) à l'intérieur de l'enveloppe (3).

2. Composant optoélectronique selon la revendication 1,
**caractérisé par le fait que** les connexions conductrices de chaleur (4, 5, 6) sont plus larges qu'une ou plusieurs connexions externes (9, 14) de la partie formant connexion.

3. Composant optoélectronique selon l'une des revendications 1 et 2,
**caractérisé par le fait que** la partie formant support de puce (2) est reliée de façon thermiquement conductrice à au moins une aile de refroidissement (15) qui dépasse de l'enveloppe (3) sur une autre surface latérale (19) de l'enveloppe que les connexions conductrices de chaleur.

4. Composant optoélectronique selon l'une des revendications 1 à 3,
**caractérisé par le fait que** l'enveloppe (3) est entièrement en un matériau transparent au rayonnement.

5. Composant optoélectronique selon l'une des revendications 1 à 3,
**caractérisé par le fait qu'**il est prévu dans l'enveloppe (3) formant le corps de base (10) un évidement (11) dans lequel une partie formant fenêtre (12) transparente au rayonnement est montée.

6. Composant optoélectronique selon la revendication 5,
**caractérisé par le fait que** la partie formant support de puce (2) est enveloppée partiellement par le corps de base (10) opaque au rayonnement, la puce (1) étant placée dans l'évidement (11).

7. Composant optoélectronique selon la revendication 5 ou 6,
**caractérisé par le fait que** l'évidement (11) est conçu avec une section transversale s'élargissant de l'intérieur de l'enveloppe (3) vers l'extérieur.

8. Composant optoélectronique selon la revendication 7,
**caractérisé par le fait que** la ou les surfaces internes de l'évidement (11) sont conçues comme des réflecteurs pour le rayonnement émis et/ou reçu par la puce (1 ).
